# EUROPEAN PATENT SPECIFICATION

(11) **EP 0 398 164 B1**
(45) Date of publication and mention of the grant of the patent: **27.10.1993**
(21) Application number: 90108847.6
(22) Date of filing: 10.05.1990
(51) Int. Cl.: H01L 39/14, H01L 39/24

(54) **Method of fabricating oxide superconducting film**
Verfahren zur Herstellung einer oxydsupraleitenden Schicht
Méthode pour fabriquer un film supraconducteur d'oxyde

(30) Priority: 19.05.1989 JP 126847/89
(43) Date of publication of application: 22.11.1990
(73) Proprietor: SUMITOMO ELECTRIC INDUSTRIES, LTD., Osaka-shi, Osaka 541 (JP)
(72) Inventor: Okuda, Shigeru, c/o Osaka Works of, Konohanaku, Osaka (JP)
(74) Representative: KUHNEN, WACKER & PARTNER

(56) References cited:
- APPLIED PHYSICS LETTERS, vol. 53, no. 16, 17th October 1988, pages 1557-1559, New York, US; B. ROAS et al.: "Epitaxial growth of YBa2Cu307-x thin films by laser evaporation process"
- APPLIED PHYSICS LETTERS, vol. 54, no. 15, 15th May 1989, pages 2035-2037, New York, US; C. GIRAULT et al.: "Influence of oxygen pressure on the characteristics of the FrF-laser-induced plasma plume created above an YBaCuO superconducting target"
- APPLIED PHYSICS LETTERS, vol. 52, no. 3, 18th January 1988, pages 239-241, New York, US; O. AUCIEILO et al.: "Surface compositional and topographical changes resulting from excimer laser impacting on YBa2Cu307 single phase superconductors"

## Description

### BACKGROUND OF THE INVENTION

The present invention relates to a method of fabricating an oxide superconducting film, and more particularly, it relates to a method of fabricating an oxide superconducting film using laser ablation or laser deposition.

From Applied Physics Letters, vol. 53, no. 16, 17th October 1988, pp. 1557-1559, an epitaxial growth of YBa₂Cu₃O₇₋ₓ thin films by a laser evaporation process is disclosed. Immediately after the deposition of the superconducting material, pure oxygen is introduced into the deposition chamber and the film temperature decreased to 600°C by heat conductivity within about 3 min. The films are then cooled down in flowing oxygen gas to ambient temperature in 1 h. With this technique, no additional oxygen plasma source is needed for the in situ crystalline growth. It is assumed that the laser beam itself seems to activate the necessary oxygen at every pulse.

With recent development of laser units, there has been proposed a laser deposition technique of applying a laser beam to a target for vaporizing or sputtering the target material and forming a film on a substrate (refer to "Saisentan Laser Kako Gijutsu" edited by Hiromichi Kawasumi, CMC Shuppan, for example).

Such a laser deposition technique has the following features:
(1) The film is generally formed at a high speed.
(2) The composition can be easily controlled.

In particular, laser ablation with an excimer pulse laser beam, which has high energy density of at least 0.5 to 1 J/cm², is highlighted as means for forming an oxide superconducting thin film of Y-Ba-Cu-O, Bi-Sr-Ca-Cu-O or the like, due to its capability of temperature reduction through photochemical reaction (refer to Appl. Phys. Lett. 53, 517 (1988) by C. C. Chang et al., for example).

It has been proved that the speed of film formation by laser ablation is proportionate to the frequency of a laser beam as used. If the frequency of a laser beam for forming an oxide superconducting film of Y-Ba-Cu-O, Bi-Sr-Ca-Cu-O or the like is simply increased, however, it is difficult to incorporate oxygen, which must be contained in such an oxide superconducting film, since the speed of film formation is too high. When an oxide superconductor contains insufficient oxygen, its critical temperature T_{C} is reduced. Thus, it is inexpedient to increase the frequency of the laser beam in order to simply improve the speed of film formation.

In more concrete terms, it is possible to form a Y-Ba-Cu-O film of about 0.1 to 0.2 nm (1 to 2 Å) in thickness every pulse by laser ablation with an ArF gas laser, for example. Thus, a film of 1800 nm (18000 Å) to 3600nm (36000 Å) in thickness can be formed per hour with a laser beam of 5 Hz, for example. However, if a film is formed with a laser beam of 10 Hz, for example, sufficient oxygen cannot be incorporated into the as-formed oxide superconducting film since the speed of film formation is too high, although the amount of film formation is theoretically doubled per unit time.

### SUMMARY OF THE INVENTION

Accordingly, an object of the present invention is to provide a method of fabricating an oxide superconducting film, which can incorporate sufficient oxygen even under a high speed of film formation.

This object is solved by the method in accordance with claim 1. The inventive method of fabricating an oxide superconducting film comprises:
a. a first deposition step of applying a laser beam to a target of an oxide superconductive material for depositing atoms and/or molecules scattered from the target on a first portion of a substrate under an atmosphere containing oxygen; and
b. a second deposition step of moving the substrate for depositing atoms and/or molecules scattered from the target on a second portion, which is different from the first portion of the substrate, under the atmosphere containing oxygen, and
c. the first and second deposition steps are repeated.

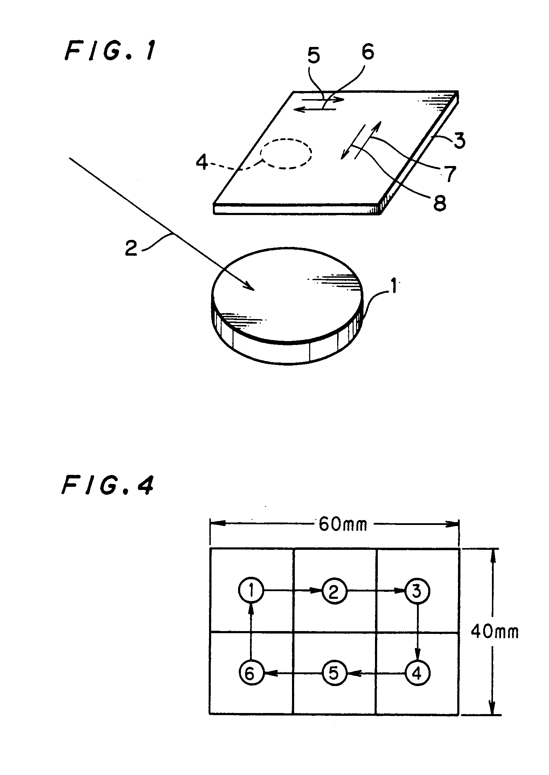

Referring to Fig.1, in more concrete terms, when a laser beam 2 is applied to a target 1, film formation is performed on a first portion 4 of a substrate 3, which is opposed to the target 1. Such film formation is carried out under an atmosphere containing oxygen. The substrate 3 is movable along arrows 5, 6, 7 and 8. Therefore, when the substrate 3 is moved in any direction, subsequent film formation is performed on a second portion which is different form the first portion 4 of the substrate 3. At this time, oxygen annealing is carried out on the first portion 4, which has been subjected to the film formation, of the substrate 3 under the atmosphere containing oxygen, so that sufficient oxygen can be incorporated into the as-formed oxide superconducting film. Such deposition and oxygen annealing are alternately repeated until an oxide superconducting film having a desired thickness is obtained.

According to the present invention, the frequency of the laser beam is preferably selected to be at least 10 Hz.

Heretofore, the frequency of a laser beam has been generally reduced below 10 Hz, in order to form an oxide superconducting film of Y-Ba-Cu-O or Bi-Sr-Ca-Cu-O through laser ablation. In general, however, the frequency of such a laser beam can be raised up to 60 Hz to 100 Hz, and it is desirable to increase the laser beam frequency in order to sufficiently effectuate the ability of the laser unit and to increase the amount of film formation per unit time.

According to the present invention, the substrate is moved after a portion thereof is subjected to film formation of 5 nm (50 Å), for example, to newly perform film formation on another portion, while the portion previously subjected to film formation is oxygen-annealed to enable incorporation of sufficient oxygen. Thus, it is possibe to use a laser beam having a frequency of at least 10 Hz, for example, thereby sufficiently effectuating the ability of the laser unit.

According to the present invention, therefore, it is possible to form an oxide superconducting film at a high speed using a high-frequency laser beam, without damaging superconducting properties. Thus, the present invention is particularly advantageously employed for the field of a magnetic shield, a superconducting wire rod or the like, which requires formation of a large amount of superconducting films.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective view illustrating the principle of the inventive method of fabricating an oxide superconducting film;
Fig. 2 illustrates relation between laser beam frequency and film weight in a reference example;
Fig. 3 illustrates relation between laser beam frequency and critical temperature T_{C} in a reference example; and
Fig. 4 is an plan view illustrating an exemplary mode of movement of film forming regions achieved by moving a substrate in Example of the present invention,

### DESCRIPTION OF THE PREFERRED EMBODMENTS

Before describing Example of the present invention, the following reference example is presented:

### Reference Example

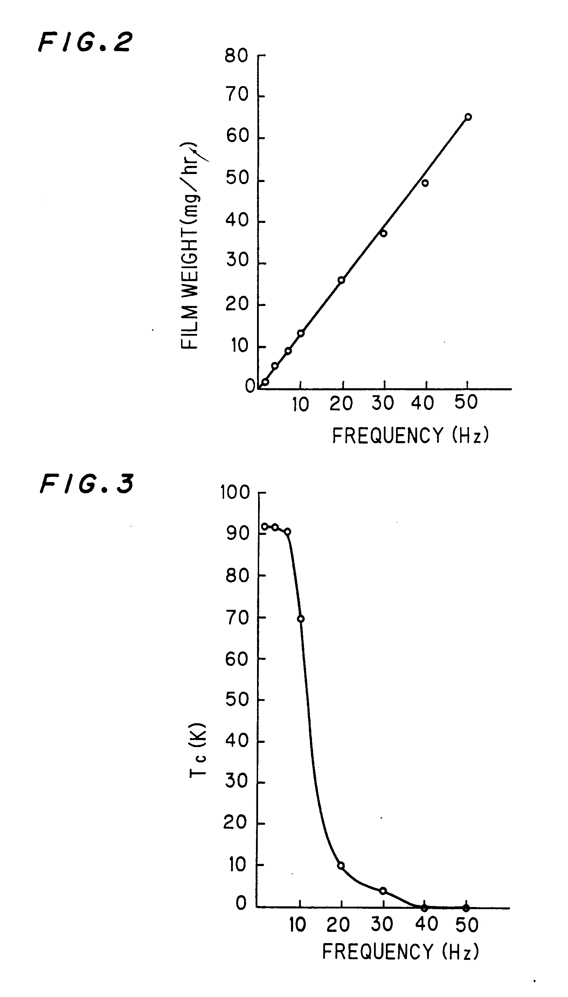

A target of Y₁ Ba₂Cu₃O_{6.9} was used to perform laser deposition with an ArF gas laser under an atmosphere having oxygen pressure of 26.7 Pa (200 mTorr). An MgO substrate was employed with a target-to-substrate distance of 40 mm and a substrate temperature of 700°C. The frequency of a laser beam having energy density of 1 J/pulse was varied within a range of 1 Hz to 50 Hz, to carry out one-hour film formation at some frequency levels within this range. Figs. 2 and 3 show values of film weight and critical temperature T_{C} thus obtained.

The film weight is increased with the frequency level as understood from Fig. 2, while the critical temperature T_{C} of the as-formed superconducting film falls below 77 K at frequency levels exceeding 10 Hz as shown in fig. 3, to result in no superconduction of the film in liquid nitrogen.

Example of the present invention is now described.

### Example

Example of the present invention was prepared with a target material, a laser, an atmosphere containing oxygen, a substrate material, a substrate temperature and a target-to-substrate distance which were similar to those of the aforementioned reference example. As shown in Fig.4, the size of the substrate was 60 mm x 40 mm, and film forming regions were moved every second as ①→②→③→④→⑤→⑥→①... Energy density of the laser beam was 1 J/pulse similarly to the reference example, while its frequency was 40 Hz.

The film weight measured after one-hour film formation was 52 mg, and critical temperature T_{C} was 90 K.

Comparing Example with the reference example, it is understood that the critical temperature of the reference example fell below 4.2 K at the laser beam frequency of 40 Hz to exhibit no superconduction in liquid nitrogen, although its film weight was substantially identical to that of Example. According to Example, on the other hand, it is possible to attain a high critical temperature T_{C} since sufficient oxygen can be simultaneously incorporated into remaining portions when film formation is performed on a certain portion.

## Claims

1. A method of fabricating an oxide superconducting film comprising:
a first deposition step of applying a laser beam (2) to a target (1) of an oxide superconductive material for depositing atoms and/or molecules scattered from said target (1) on a first portion (4) of a substrate (3) under atmosphere containing oxygen; and
a second deposition step of moving said substrate (3) for depositing atoms and/or molecules scattered from said target (1) on a second portion of said substrate (3), being different from said first portion (4) of said substrate (3), under said atmosphere containing oxygen, so that film formation is performed on said second portion of said substrate (3), while said first portion (4) of the substrate (3) previously subjected to film formation is oxygen-annealed to enable incorporation of sufficient oxygen,
said first and second deposition steps being alternately repeated.

2. A method of fabricating an oxide superconducting film in accordance with claim 1, wherein said laser beam (2) is a pulsed beam having a frequency of at least 10 Hz.

## Patentansprüche

1. Verfahren zum Herstellen eines supraleitenden Oxidfilms, mit:
einem ersten Ablagerungsschritt durch Beaufschlagen eines Targets (1) aus einem supraleitendem Oxidmaterial mit einem Laserstrahl (2), um unter einer Atmosphäre, die Sauerstoff enthält, aus dem Target (1) herausgeschlagene Atome und/oder Moleküle auf einem ersten Teil (4) eines Substrats (3) abzulagern; und
einem zweiten Ablagerungsschritt, während dem das Substrat (3) bewegt wird, um unter der Atmosphäre, die Sauerstoff enthält, aus dem Target (1) herausgeschlagene Atome und/oder Moleküle auf einem zweiten Teil des Substrats (3), der sich von dem ersten Teil (4) des Substrats (3) unterscheidet, abzulagern, so daß die Filmbildung auf dem zweiten Teil des Substrats (3) erfolgt, während der erste Teil (4) des Substrats (3), auf dem die Filmbildung zuvor erfolgt ist, mit Sauerstoff getempert wird, um den Einbau von genügend Sauerstoff zu ermöglichen,
wobei der erste und der zweite Ablagerungsschritt abwechselnd wiederholt werden.

2. Verfahren zum Herstellen eines supraleitenden Oxidfilms gemäß Anspruch 1, worin der Laserstrahl (2) ein gepulster Strahl mit einer Frequenz von 10 Hz ist.

## Revendications

1. Procédé de fabrication d'un film supraconducteur oxyde comprenant:
une première étape de dépôt consistant à appliquer un faisceau laser (2) sur une cible (1) en un matériau supraconducteur oxyde pour déposer des atomes et/ou des molécules dispersées à partir de ladite cible (1) sur une première portion (4) d'un substrat (3) sous une atmosphère contenant de l'oxygène; et
une seconde étape de dépôt consistant à déplacer ledit substrat (3) pour déposer les atomes et/ou les molécules dispersées à partir de ladite cible (1) sur une seconde portion dudit substrat (3) qui est différente de ladite première portion (4) dudit substrat (3), dans ladite atmosphère contenant de l'oxygène, de manière que la formation du film soit effectuée sur ladite seconde portion du substrat (3) alors que ladite première portion (4) du substrat (3) précédemment soumise à la formation d'un film est recuite à l'oxygène pour permettre l'incorporation d'une quantité suffisante d'oxygène,
lesdites première et seconde étapes de dépôt étant répétées alternativement.

2. Procédé de fabrication d'un film supraconducteur oxyde selon la revendication 1, dans lequel ledit faisceau laser (2) est un faisceau pulsé à la fréquence de 10 Hz.
